# EUROPEAN PATENT SPECIFICATION

(11) **EP 2 757 613 B1**
(45) Date of publication and mention of the grant of the patent: **18.11.2015**
(21) Application number: 13183848.4
(22) Date of filing: 11.09.2013
(51) Int. Cl.: H01M 2/20, H01M 2/34, H01M 10/42, H05K 1/00, H05K 3/34, H05K 3/40, H01M 2/10

(54) **Rechargeable battery pack**
Wiederaufladbares Batteriepaket
Bloc-batterie rechargeable

(30) Priority: 22.01.2013 US 201361755318 P; 05.09.2013 US 201314019486
(43) Date of publication of application: 23.07.2014
(73) Proprietor: Samsung SDI Co., Ltd., Yongin-si 449-577 (KR)
(72) Inventor: Yi, Sang-Il, YONGIN-SI (KR); Kang, Moon-Gil, YONGIN-SI (KR)
(74) Representative: Gulde & Partner

(56) References cited:
- EP-A1- 2 187 465
- EP-A2- 2 337 116
- JP-A- H0 887 992
- US-A1- 2006 032 667

## Description

### BACKGROUND

### 1. Field

The described technology relates generally to a rechargeable battery pack. More particularly, the described technology relates generally to a rechargeable battery pack in which the structure of a protective circuit board combined with connection tabs is improved.

### 2. Description of the Related Art

With the technical development of and the increasing demand for mobile devices, demand for rechargeable batteries as energy sources is increasing. A rechargeable battery is used in the form of a single cell and is used in the form of a pack in which a plurality of cells are electrically connected to each other in accordance with the type of a used device.

In general, a cylindrical rechargeable battery has larger capacity than that of a square type rechargeable battery or a pouch type rechargeable battery. Cylindrical rechargeable batteries may be serially connected, connected in parallel, or connected in a mixed structure to form a rechargeable battery pack in a linear or plate structure.

The rechargeable battery pack is formed by connecting portion cells to each other by connection tabs to form a cell pack and by electrically connecting the connection tabs of the cell pack to a protective circuit module (PCM). The protective circuit module is formed to protect the cell pack against overcharge, over-discharge, over-current, and short.

For example, the protective circuit module has through-holes. The ends of the connection tabs are inserted into the through-holes and are electrically connected to the protective circuit module by soldering.

Examples of such battery packs known in the art are disclosed in EP 2 337 116 A2, US 2006/0032667 A1 and EP 2 187 465 A1.

Therefore, since plumbic acid is formed in a soldering region around the through-holes of the protective circuit module with which the ends of the connection tabs are combined, the volume of the soldering region increases in comparison with the remaining parts of the protective circuit module.

As a result, since the volume of the protective circuit module is increased by the plumbic acid, it is not possible to design the rechargeable battery pack to be thin.

The above information disclosed in this Background section is only for enhancement of understanding of the background of the described technology and therefore it may contain information that does not form the prior art that is already known in this country to a person of ordinary skill in the art.

### SUMMARY

The described technology has been made in an effort to provide a rechargeable battery pack having advantages of reducing the volume of a protective circuit module.

Therefore, in order to solve the conventional problem, the object of the present invention is to provide a rechargeable battery pack including a protective circuit board and connection tabs capable of reducing the volume of a protective circuit module.

A rechargeable battery pack according to an exemplary embodiment includes a plurality of unit cells, connection tabs for electrically connecting the plurality of unit cells to each other, connection plates combined with the connection tabs, and a protective circuit module in which grooves with which the connection plates are combined are formed.

According to an exemplary embodiment, it is possible to prevent plumbic acid from being formed on the protective circuit board to reduce the volume of the rechargeable battery pack.

The rechargeable battery pack of the present invention comprises:
a plurality of unit cells;
connection tabs for electrically connecting the plurality of unit cells to each other;
a protective circuit board in which combination grooves are formed; and
connection plates combined with the connection tabs and disposed on a first surface of the protective circuit board to face the combination grooves,
wherein the first surface of the protective circuit board faces the connection tabs.The combination of connection plates and a protective circuit board with combination grooves proposed with the present invention ensures the formation of a space, deepening or depression which allows to electrically connect the connection tabs and the protective circuit board by soldering without the need to increase the volume of the rechargeable battery pack of the invention by the plumbic acid formed on the protective circuit board.

Preferably, the rechargeable battery pack of the invention comprises:
a plurality of unit cells;
a first and a second connection tab for electrically connecting the plurality of unit cells to each other;
a first and a second connection plate combined with the first and second connection tabs respectively; and
a protective circuit board in which a first combination groove and a second combination groove are facing
the first connection plate and the second connection plate, respectively.

In the rechargeable battery pack of the invention, the connection plates are preferably formed of conductive material to be electrically connected to the protective circuit board.

Preferably, the connection tabs of the rechargeably battery pack of the invention comprise a body and a protruding portion extending from one side of the body towards the respective connection plate.

The connection plates of the rechargeable battery pack of the invention may include a connecting portion and a through-hole formed in said connecting portion, wherein a protruding portion of the respective connection tab may be inserted and combined with said through-hole.

In the rechargeable battery pack of the invention, the protruding portion of the connection tabs (30, 40) is preferably combined with a connection portion of the respective connection plate by soldering.

Preferably, the protruding portion of the respective connection tab is inserted into the through-hole of said connection plate such that the tip of the protruding portion is positioned not to extend above the plane of a second surface of the protective circuit board opposite to the first surface. Preferably, the tip of the protruding portion is positioned between the first surface and the second surface of the protective circuit board.

The rechargeable battery pack of the invention can further comprise a plumbic acid which combines the protruding portion of the connecting tab with the connecting portion of the connection plate, wherein the height H1 of the plumbic acid does not extend above the plane of the second surface of the protective circuit board.

In the rechargeable battery pack of the invention, the connection plates may further comprise a plurality of protrusions on the surface opposed to the first surface of the protective circuit board.

The connection plates of the rechargeable battery pack of the invention may further comprise a blocking protrusion extending from one end of the connecting portion, wherein the blocking protrusion engages with a combining groove of the protective circuit board.

Further, the connection plates may comprise at least one groove on the surface opposed to the first surface of the protective circuit board.

In the rechargeable battery pack of the invention, the connection plates may further comprise a fixing portion which protrudes from one side surface of the connection portion and is formed to combine with the respective combination groove of the protective circuit board, preferably by a press-fit technology. In a preferred embodiment, the side surface of the fixing portion is positioned to face the internal side surface of the respective combination groove of the protective circuit board.

The connection plates of the rechargeable battery pack of the invention may further comprise a convex portion which extends from one end of the connecting portion in a direction away from the first surface of the protective circuit board. In a preferred embodiment, the connection plates may further comprise a combination protrusion extending from a bottom surface of the convex portion and being formed so that the end of the combination protrusion is positioned between the first surface and the second surface of the protective circuit board.

### BRIEF DESCRIPTION OF THE DRAWINGS

FIG. 1 is a perspective view schematically illustrating a rechargeable battery pack according to a first exemplary embodiment of the present invention.
FIG. 2 is an exploded perspective view of the rechargeable battery pack of FIG. 1.
FIG. 3 is a partial cross-sectional view of the rechargeable battery pack taken along the line III-III in FIG. 1.
FIG. 4 is a perspective view of a connection plate according to an exemplary variation of the first exemplary embodiment of the present invention.
FIG. 5 is a partial perspective view of a rechargeable battery pack according to a second exemplary embodiment of the present invention.
FIG. 6 is a cross-sectional view taken along the line VI-VI in FIG. 5.
FIG. 7 is a partial perspective view of a rechargeable battery pack according to a third exemplary embodiment of the present invention.
FIG. 8 is a cross-sectional view taken along the line VIII-VIII in FIG. 7.
FIG. 9 is a partial perspective view of a rechargeable battery pack according to a fourth exemplary embodiment of the present invention.
FIG. 10 is a cross-sectional view taken along the line X-X in FIG. 9.
FIG. 11 is a partial cross-sectional view of a rechargeable battery pack according to a fifth exemplary embodiment of the present invention.
FIG. 12 is a partial cross-sectional view of a rechargeable battery pack according to a sixth exemplary embodiment of the present invention.

### DETAILED DESCRIPTION

Hereinafter, exemplary embodiments of the present invention will be described in detail with reference to the accompanying drawings so that a person of ordinary skill in the art may easily perform the present invention. As those skilled in the art would realize, the described embodiments may be modified in various different ways, all without departing from the scope of the present invention as defined in the claims.

The drawings and description are to be regarded as illustrative in nature and not restrictive. Like reference numerals designate like elements throughout the specification.

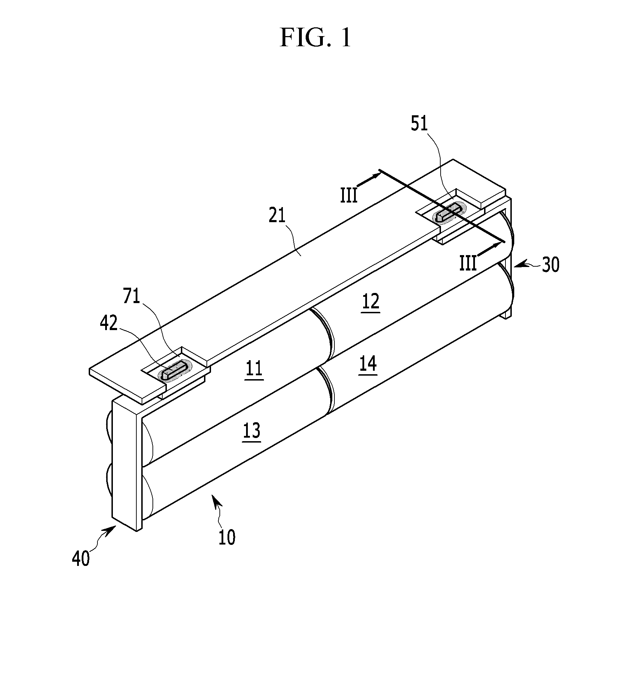

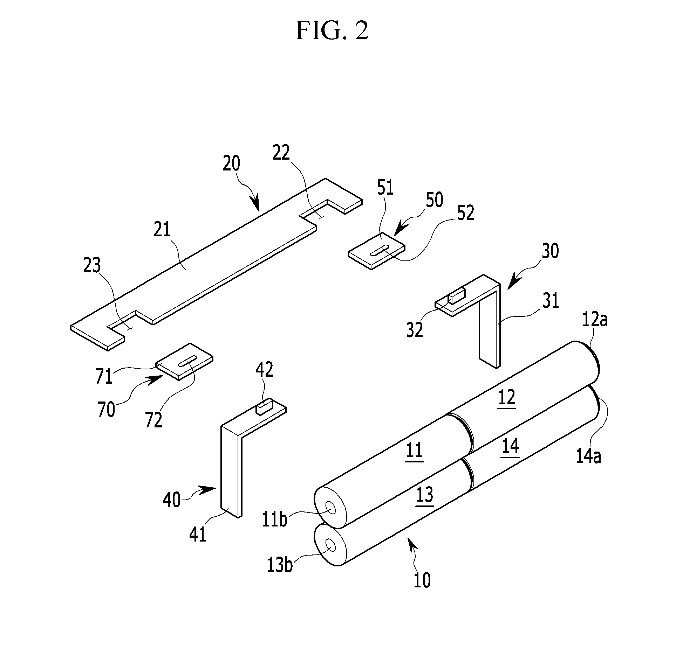

FIG. 1 is a perspective view schematically illustrating a rechargeable battery pack according to a first exemplary embodiment of the present invention. FIG. 2 is an exploded perspective view of the rechargeable battery pack of FIG. 1.

Referring to FIGs. 1 and 2, a rechargeable battery pack 100 according to the present exemplary embodiment includes a unit cell group 10 including first to fourth unit cells 11, 12, 13, and 14, a protective circuit module 20 electrically connected to the unit cell group 10, a first connection tab 30, a second connection tab 40, a first connection plate 50, and a second connection plate 70.

In the unit cell group 10 according to the present exemplary embodiment, the first unit cell 11 and the second unit cell 12 may be serially connected, the third unit cell 13 and the fourth unit cell 14 may be serially connected, and the serially connected first and second unit cells 11 and 12 and the serially connected third and fourth unit cells 13 and 14 may be connected in parallel.

More concretely, the first connection tab 30 is combined with positive terminals 12a and 14a of the second and fourth unit cells 12 and 14 and the second connection tab 40 is combined with negative terminals 11 b and 13b of the first and third unit cells 11 and 13 so that the first and second unit cells 11 and 12 and the third and fourth unit cells 13 and 14 may be connected in parallel.

The unit cell group 10 according to the present exemplary embodiment is not limited to including the four first to fourth unit cells 11, 12, 13, and 14 but may include at least two or five unit cells so that the unit cells may be serially connected and/or connected in parallel.

The first to fourth unit cells 11, 12, 13, and 14 according to the present exemplary embodiment are described to be cylindrical. The present invention is not limited to the above but the unit cells of the present invention may be of prismatic type or pouch type.

Protective circuit elements (not shown) may be mounted in the protective circuit module 20 according to the present exemplary embodiment so that the first to fourth unit cells 11, 12, 13, and 14 may protect the rechargeable battery pack 100 against overcharge, over-discharge, over-current, and short that may be generated in the rechargeable battery pack 100.

More concretely, the protective circuit module 20 according to the present exemplary embodiment may include a protective circuit board 21.

Here, in the protective circuit board 21 according to the present exemplary embodiment, a first combination groove 22 and a second combination groove 23 are formed so that the first connection plate 50 and the second connection plate 70 may be combined with the first combination groove 22 and the second combination groove 23, respectively.

Here, the first and second connection plates 50 and 70 may be formed of a conductive material to be electrically connected to the protective circuit board 21.

In addition, the first connection tab according to the present exemplary embodiment may include a first body 31 and a first protruding portion 32 extended from one side of the first body 31 and the second connection tab 40 may include a second body 41 and a second protruding portion 42 extended from one side of the second body 41.

In addition, the first connection plate 50 according to the present exemplary embodiment may include a first connecting portion 51 and a first through-hole 52 formed to penetrate the first connecting portion 51 and the second connection plate 70 may include a second connecting portion 71 and a second through-hole 72 formed to penetrate the second connecting portion 71.

According to the present exemplary embodiment, the first and second bodies 31 and 41 of the first and second connection tabs 30 and 40 may be combined with the negative electrodes 11 b and 13b of the first and third unit cells 11 and 13.

In addition, the first and second protruding portions 32 and 42 of the first and second connection tabs 30 and 40 according to the present exemplary embodiment may be inserted into and combined with the first and second through-holes 52 and 72 formed in the first and second connection plates 50 and 70.

Therefore, according to the present exemplary embodiment, the unit cell group 10 and the protective circuit module 20 may be electrically connected through the first and second connection tabs 30 and 40.

At this time, the first and second protruding portions 32 and 42 of the first and second connection tabs 30 and 40 may be combined with the first connecting portions 51 and 71 of the first and second connection plates 50 and 70 by soldering.

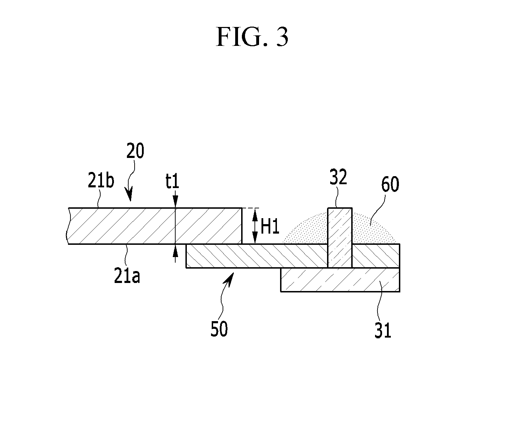

FIG. 3 is a partial cross-sectional view of the rechargeable battery pack taken along the line III-III in FIG. 1.

Referring to FIG. 3, the first protruding portion 32 of the first connection tab 30 according to the present exemplary embodiment may be inserted into the first through-hole 52 formed in the first connecting portion 51 of the first connection plate 50.

Since the second connection tab 40 and the second connection plate 70 according to the present exemplary embodiment have the same structure and combination relationship as those of the first connection tab 30 and the first connection plate 50, hereinafter, detailed description of the second connection tab 40 and the second connection plate 70 will be omitted.

Here, the first connecting portion 51 of the first connection plate 50 may be combined with a first surface 21a of the protective circuit board 21 and the first protruding portion 32 is preferably inserted into the first through-hole 52 so that an end or tip 321 thereof is positioned on the same plane as a second surface 21b of the protective circuit board 21 or, in other words, is positioned not to extend above the plane of the second surface 21 b of the protective circuit board 21.

In addition, the first protruding portion 32 of the first connection tab 30 and the first connecting portion 51 of the first connection plate 50 may be combined by soldering.

Therefore, according to the present exemplary embodiment, a plumbic acid 60 that combines the first protruding portion 32 with the first connecting portion 51 may be formed.

Here, since the end 321 of the first protruding portion 32 is positioned on the same plane as the second surface 21b of the protective circuit board 21 or below, the plumbic acid 60 according to the present exemplary embodiment may be formed between the second surface 21b of the protective circuit board 21 and the first connecting portion 51.

For example, the height H1 of the plumbic acid 60 according to the present exemplary embodiment may be identical to or smaller than a thickness t1 between the first surface 21a and the second surface 21b of the protective circuit board 21.

Therefore, according to the present exemplary embodiment, when the unit cell group 10 and the protective circuit module 20 are connected by soldering, it is possible to prevent the volume of the rechargeable battery pack from being increased by the plumbic acid 60 formed on the protective circuit board 21.

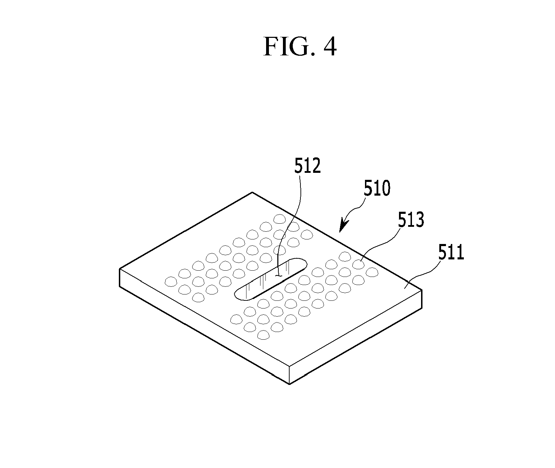

FIG. 4 is a perspective view of a connection plate according to an exemplary variation of the first exemplary embodiment of the present invention.

Since the rechargeable battery pack according to the present exemplary embodiment has the same structure as that of the rechargeable battery pack 100 according to the first exemplary embodiment of the present invention excluding a first connection plate 510 and a second connection plate (not shown), hereinafter, detailed description of the same structure will be omitted.

The first connection plate 510 according to the present exemplary embodiment may include a first connecting portion 511 and a first through-hole 512 formed to penetrate the first connecting portion 511.

Here, since the first connection plate 510 and the second connection plate (not shown) according to the present exemplary embodiment have the same structure, hereinafter, detailed description of the second connection plate (not shown) will be omitted.

A plurality of protrusions 513 may be formed in the first connecting portion 511 of the first connection plate 510 according to the present exemplary embodiment.

Therefore, according to the present exemplary embodiment, since the surface area of the first connecting portion 511 of the first connection plate 510 is increased by the plurality of protrusions 513, a plumbic acid (not shown) may be stably formed between the first connecting portion 511 and the first protruding portion 32.

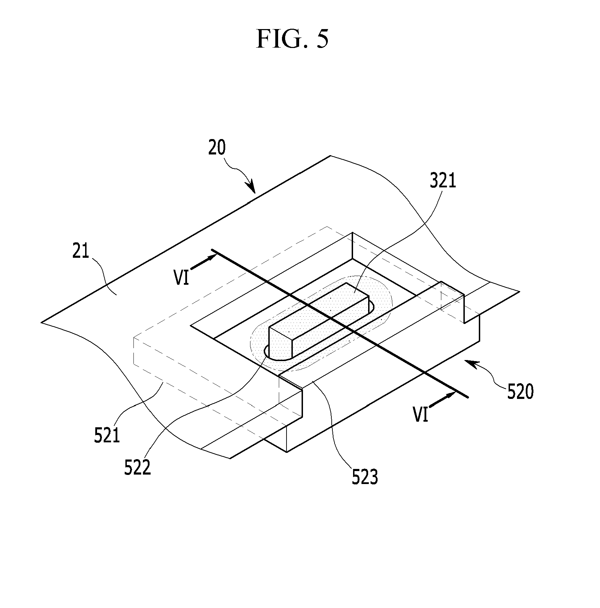

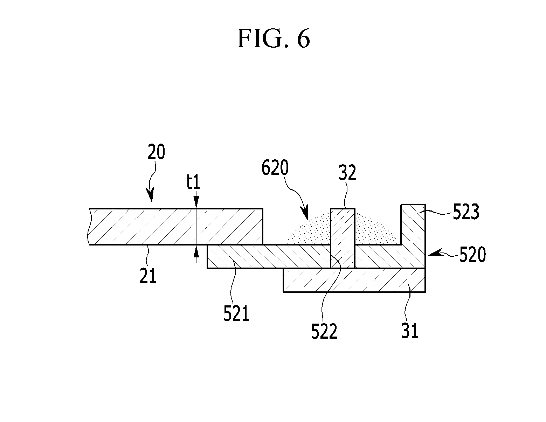

FIG. 5 is a partial perspective view of a rechargeable battery pack according to a second exemplary embodiment of the present invention. FIG. 6 is a cross-sectional view taken along the line VI-VI in FIG. 5.

Since a rechargeable battery pack according to the present exemplary embodiment has the same structure as that of the rechargeable battery pack 100 according to the first exemplary embodiment of the present invention excluding a first connection plate 520 and a second connection plate (not shown), hereinafter, detailed description of the same structure will be omitted.

Referring to FIGs. 5 and 6, the first connection plate 520 according to the present exemplary embodiment may include a first connecting portion 521, a first through-hole 522, and a first blocking protrusion 523.

Here, since the second connection plate (not shown) according to the present exemplary embodiment has the same structure as that of the first connection plate 520, hereinafter, detailed description of the second connection plate (not shown) will be omitted.

The first blocking protrusion 523 of the first connection plate 520 according to the present exemplary embodiment may be extended from one end of the first connecting portion 521.

For example, the first blocking protrusion 523 according to the present exemplary embodiment may be extended from one end of the first connecting portion 521 to approximately run parallel with the direction of the thickness t1 of the protective circuit board 21.

Therefore, a plumbic acid 620 according to the present exemplary embodiment may be formed between the first blocking protrusion 523 and the protective circuit board 21.

That is, according to the present exemplary embodiment, when the first connecting portion 521 and the first protruding portion 32 are connected by soldering, it is possible to prevent lead molten to form the plumbic acid 620 from flowing down the outside of the first connecting portion 521 due to the first blocking protrusion 523 formed at one end of the first connecting portion 521.

According to the present exemplary embodiment, not only the first blocking protrusion 523 is formed in the first connection plate 520.

Therefore, together with the first blocking protrusion 523 formed at the end of the first connecting portion 521, a plurality of protrusions (not shown) may be formed around the first through-hole 522.

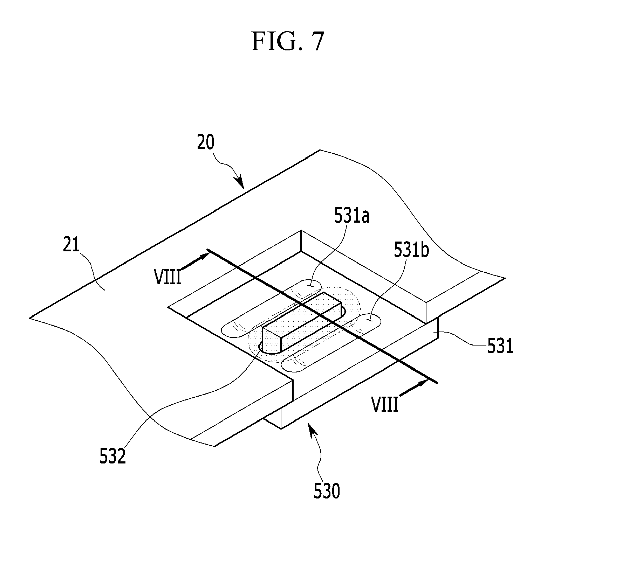

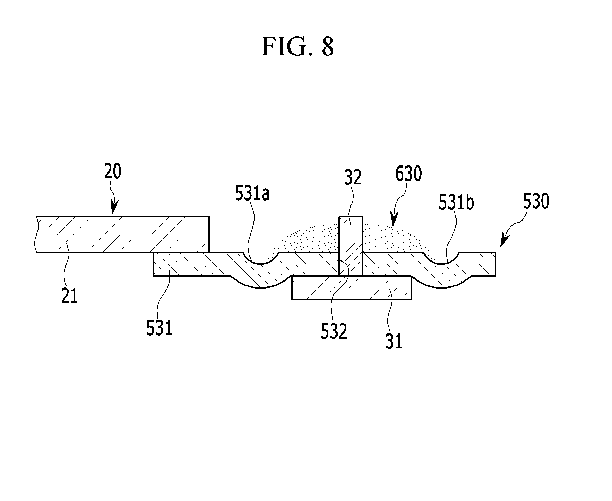

FIG. 7 is a partial perspective view of a rechargeable battery pack according to a third exemplary embodiment of the present invention. FIG. 8 is a cross-sectional view taken along the line VIII-VIII in FIG. 7.

Since a rechargeable battery pack according to the present exemplary embodiment has the same structure as that of the rechargeable battery pack 100 according to a first exemplary embodiment of the present invention excluding a first connection plate 530 and a second connection plate (not shown), hereinafter, detailed description of the same structure will be omitted.

Referring to FIGs. 7 and 8, a first connection plate 530 according to the present exemplary embodiment may include a first connecting portion 531 in which first and second grooves 531a and 531b are formed and a first through-hole 532.

Here, since a second connection plate (not shown) according to the present exemplary embodiment has the same structure as that of the first connection plate 530, hereinafter, detailed description of the second connection plate (not shown) will be omitted.

The first and second grooves 531a and 531b of the first connecting portion 531 according to the present exemplary embodiment may be formed at both sides of the first through-hole 532 at uniform intervals.

In addition, a plumbic acid 630 according to the present exemplary embodiment may be formed between the first and second grooves 531a and 531b to connect the first connecting portion 531 and the first protruding portion 32 of the first connection tab 30.

Therefore, according to the present exemplary embodiment, when the first connecting portion 531 and the first protruding portion 32 are connected by soldering, it is possible to prevent lead molten to form the plumbic acid 630 from flowing down the outside of the first connecting portion 531 due to the first and second grooves 531a and 531 b formed in the first connecting portion 531.

Not only the first and second grooves 531a and 531b are formed in the first connection plate 530 according to the present exemplary embodiment.

Therefore, in the first connection plate 530, together with the first and second grooves 531a and 531b, a blocking protrusion (not shown) may be formed at the end of the first connecting portion 531 and a plurality of protrusions (not shown) may be formed around the first through-hole 532 formed in the first connecting portion 531.

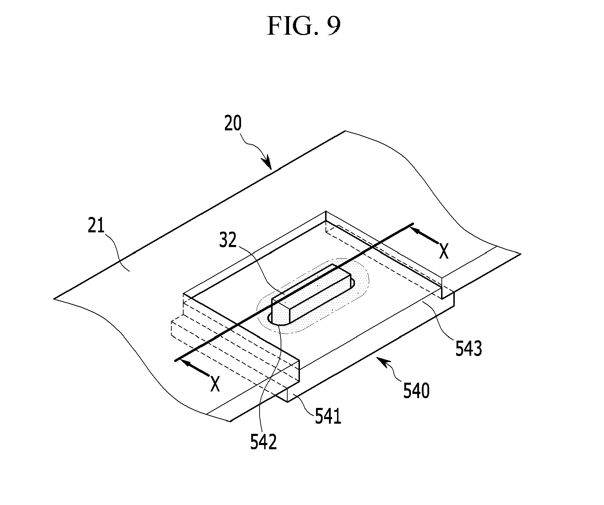

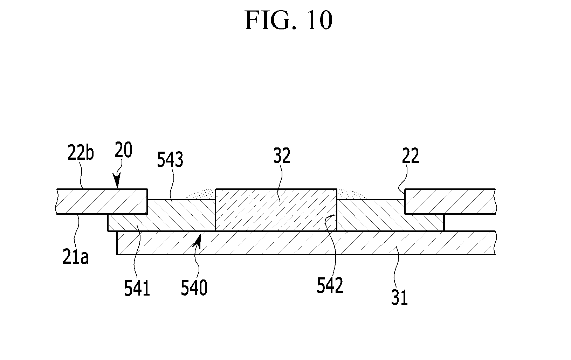

FIG. 9 is a partial perspective view of a rechargeable battery pack according to a fourth exemplary embodiment of the present invention. FIG. 10 is a cross-sectional view taken along the line X-X in FIG. 9.

Since a rechargeable battery pack according to the present exemplary embodiment has the same structure as that of the rechargeable battery pack 100 according to the first exemplary embodiment of the present invention excluding a first connection plate 540 and a second connection plate (not shown), hereinafter, detailed description of the same structure will be omitted.

Referring to FIGs. 9 and 10, the first connection plate 540 according to the present exemplary embodiment may include a first connecting portion 541, a first through-hole 542 and a first fixing portion 543.

Here, since the second connection plate according to the present exemplary embodiment has the same structure as that of the first connecting plate 540, hereinafter, detailed description of the second connection plate (not shown) will be omitted.

The first fixing portion 543 of the first connection plate 540 according to the present exemplary embodiment may protrude from one side surface of the first connecting portion 541 to be combined with the first combination groove 22 of the protective circuit board 21 by a press-fit technology.

More concretely, the side surface of the first fixing portion 543 according to the present exemplary embodiment may be provided to be positioned to face the internal side surface of the first combination groove 22.

In addition, the first protruding portion 32 of the first connection tab 30 may be fixed to the first through-hole 542 formed to penetrate the first connecting portion 541 and the first fixing portion 543.

Therefore, according to the present exemplary embodiment, since the first connecting portion 541 is combined with the first surface 21a of the protective circuit board 21 by welding and the first fixing portion 543 is fixed to the first combination groove 22 by the press-fit technology, the first connection plate 540 may be stably combined with the protective circuit board.

Not only the first fixing portion 543 is formed in the first connection plate 540 according to the present exemplary embodiment.

Therefore, in the first connection plate 540, together with the first fixing portion 543, first and second grooves (not shown) may be formed, a blocking protrusion (not shown) may be formed at the end of the first connecting portion 541, and a plurality of protrusions (not shown) may be formed around the first through-hole 542.

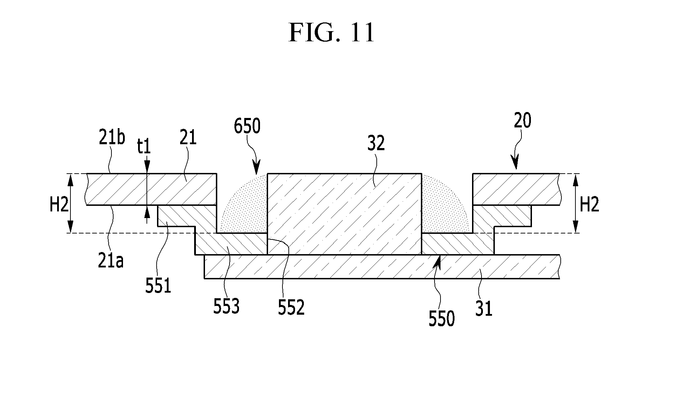

FIG. 11 is a partial cross-sectional view of a rechargeable battery pack according to a fifth exemplary embodiment of the present invention.

Since a rechargeable battery pack according to the present exemplary embodiment has the same structure as that of the rechargeable battery pack 100 according to the first exemplary embodiment of the present invention excluding a first connection plate 550 and a second connection plate (not shown), hereinafter, detailed description of the same structure will be omitted.

Referring to FIG. 11, the first connection plate 550 according to the present exemplary embodiment may include a first connecting portion 551, a first through-hole 552, and a first convex portion 553.

Here, since the second connection plate (not shown) according to the present exemplary embodiment has the same structure as that of the first connection plate 550, hereinafter, detailed description of the second connection plate (not shown) will be omitted.

The first convex portion 553 according to the present exemplary embodiment may be extended from one end of the first connecting portion 551 in a direction away from the first surface 21a of the protective circuit board 21.

More concretely, the first convex portion 553 according to the present exemplary embodiment is formed in a space between the first surface 21a and the unit cell group 10 and the first through-hole 552 is formed in the first convex portion 553 so that the first protruding portion 32 of the first connection tab 30 may be inserted into the first through-hole 552.

Therefore, the height H2 of a plumbic acid 650 formed between the first convex portion 553 according to the present exemplary embodiment and the first connection tab 30 may be approximately identical to the thickness t1 of the protective circuit board 21 and the depth D1 of the first convex portion 553.

As a result, according to the present exemplary embodiment, since the height H2 of the plumbic acid 650 increases by the depth D1 of the first convex portion 553, the first connection plate 550 may be stably combined with the protective circuit board 21.

Not only the first convex portion 553 is formed in the first connection plate 550 according to the present exemplary embodiment.

Therefore, according to the present exemplary embodiment, together with the first convex portion 553 formed in the first connection plate 550, first and second grooves (not shown) may be formed in the first convex portion 553, a blocking protrusion (not shown) may be formed at the end of the first convex portion 553, and a plurality of protrusions (not shown) may be formed around the first through-hole 552.

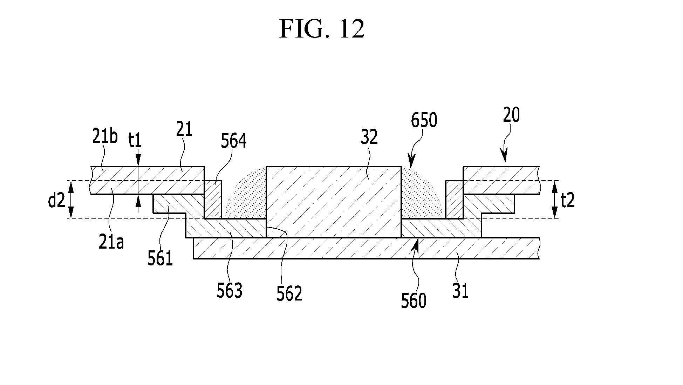

FIG. 12 is a partial cross-sectional view of a rechargeable battery pack according to a sixth exemplary embodiment of the present invention.

Since a rechargeable battery pack according to the present exemplary embodiment has the same structure as that of the rechargeable battery pack 100 according to the first exemplary embodiment of the present invention excluding a first connection plate 560 and a second connection plate (not shown), hereinafter, detailed description of the same structure will be omitted.

Referring to FIG. 12, the first connection plate 560 according to the present exemplary embodiment may include a first connecting portion 561, a first through-hole 562, a first convex portion 563, and a first combination protrusion 564.

Here, since the second connection plate (not shown) according to the present exemplary embodiment has the same structure as the first connection plate 560, hereinafter, detailed description of the second connection plate (not shown) will be omitted.

In addition, since the first connection plate 560 according to the present exemplary embodiment has the same structure as the first connection plate 550 according to the fifth exemplary embodiment of the present invention excluding the first combination protrusion 564, hereinafter, detailed description of the same structure will be omitted.

The first combination protrusion 564 of the first connection plate 560 according to the present exemplary embodiment may be extended from the bottom surface of the first convex portion 563.

More concretely, the first combination protrusion 564 according to the present exemplary embodiment may be formed so that the end thereof is positioned between the first surface 21 a and the second surface 21 b of the protective circuit board 21 from the bottom surface of the first convex portion 563.

Therefore, the thickness t2 of the first combination protrusion 564 according to the present exemplary embodiment may be identical to the depth D2 of the first convex portion 563.

In addition, the first combination protrusion 564 according to the present exemplary embodiment may include a pair of combination protrusions separated from the first convex portion 563 at uniform intervals.

In addition, the first combination protrusion 564 according to the present exemplary embodiment may be fixed to the first combination groove 22 by the press-fit technology or by welding.

As a result, according to the present exemplary embodiment, since the first connection portion 561 is combined with the first surface 21a of the protective circuit board 21 and the first combination protrusion 564 is combined with the first combination groove 22, the first connection plate 560 may be stably fixed to the protective circuit board 21.

Not only the first convex portion 563 and the first combination protrusion 564 are formed in the first connection plate 560 according to the present exemplary embodiment.

Therefore, according to the present exemplary embodiment, together with the first convex portion 563 formed in the first connection plate 560, first and second grooves (not shown) may be formed in the first convex portion 553, a blocking protrusion (not shown) may be formed at the end of the first convex portion 553, and a plurality of protrusions (not shown) may be formed around the first through-hole 552.

## Claims

1. Rechargeable battery pack, comprising
a plurality of unit cells (11, 12, 13, 14);
connection tabs (30, 40) for electrically connecting the plurality of unit cells (11, 12, 13, 14) to each other;
a protective circuit board (21) in which combination grooves (22, 23) are formed, **characterised by**
connection plates (50, 70) combined with the connection tabs (30, 40) and disposed on a first surface (21a) of the protective circuit board (21) to face the combination grooves (22, 23),
wherein the first surface (21a) of the protective circuit board (21) faces the connection tabs (30, 40).

2. Rechargeable battery pack of claim 1, comprising
a plurality of unit cells (11, 12, 13, 14);
a first (30) and a second (40) connection tab for electrically connecting the plurality of unit cells (11, 12, 13, 14) to each other;
a first (50) and a second (70) connection plate combined with the first (30) and second (40) connection tabs respectively; and
a protective circuit board (21) in which a first combination groove (22) and a second combination groove (23) are facing
the first connection plate (50) and the second connection plate (70), respectively.

3. Rechargeable battery pack of one of the preceding claims, wherein the connection plates (50, 70) are formed of conductive material to be electrically connected to the protective circuit board (21).

4. Rechargeable battery pack of one of the preceding claims, wherein each connection tab (30, 40) comprises a body (31, 41) and a protruding portion (32, 42) extending from one side of the body (31, 41) towards the respective connection plate (50, 70).

5. Rechargeable battery pack of one of the preceding claims, wherein each connection plate (50, 70) includes a connecting portion (51, 71) and a through-hole (52, 72) formed in said connecting portion (51, 71), and wherein a protruding portion (32, 42) of the respective connection tab (30, 40) is inserted and combined with said through-hole (52, 72).

6. Rechargeable battery pack of one of claims 4 or 5, wherein the protruding portion (32, 42) of each connection tab (30, 40) is combined with a connection portion (51, 71) of a respective connection plate (50, 70) by soldering.

7. Rechargeable battery pack of one of claims 4 to 6, wherein the protruding portion (32, 42) of the respective connection tab (30, 40) is inserted into the through-hole (52, 72) of said connection plate (50, 70) such that the tip (321) of the protruding portion (32, 42) is positioned not to extend above the plane of a second surface (21b) of the protective circuit board (21) opposite to the first surface (21a).

8. Rechargeable battery pack of claim 7, further comprising a plumbic acid (60) which combines the protruding portion (32, 42) of the connecting tab (30, 40) with the connecting portion (51, 71) of the connection plate (50, 70), wherein the height H1 of the plumbic acid (60) does not extend above the plane of the second surface (21b) of the protective circuit board (21).

9. Rechargeable battery pack of one of the preceding claims, wherein the connection plates further comprise a plurality of protrusions (513) on the surface opposed to the first surface (21a) of the protective circuit board (21).

10. Rechargeable battery pack of one of claims 5 to 9, wherein the connection plates comprise a blocking protrusion (522) extending from one end of the connecting portion, wherein the blocking protrusion (522) engages with a combining groove of the protective circuit board (21).

11. Rechargeable battery pack of one of the preceding claims, wherein the connection plates comprise at least one groove (531a, 531b) on the surface opposed to the first surface (21a) of the protective circuit board (21).

12. Rechargeable battery pack of one claims 5 to 11, wherein the connection plates further comprise a fixing portion (543) which protrudes from one side surface of the connection portion and is formed to combine with the respective combination groove of the protective circuit board (21) by a press-fit technology.

13. Rechargeable battery pack of claim 12, wherein the side surface of the fixing portion (543) is positioned to face the internal side surface of the respective combination groove of the protective circuit board (21).

14. Rechargeable battery pack of one of claims 5 to 13, wherein the connection plates further comprise a convex portion (553, 563) which extends from one end of the connecting portion in a direction away from the first surface of the protective circuit board (21).

15. Rechargeable battery pack of claim 14, wherein the connection plates further comprise a combination protrusion (564) extending from a bottom surface of the convex portion (553, 563) and being formed so that the end of the combination protrusion (564) is positioned between the first surface (21a) and the second surface (21b) of the protective circuit board (21).

## Patentansprüche

1. Wiederaufladbares Batteriepaket, umfassend:
eine Mehrzahl von Elementarzellen (11, 12, 13, 14);
Verbindungsstreifen (30, 40) zum elektrischen Verbinden der Mehrzahl von Elementarzellen (11, 12, 13, 14) miteinander;
eine Schutzstromkreisplatte (21), in der Kombinationsnuten (22, 23) ausgebildet sind,
**gekennzeichnet durch**
Verbindungsplatten (50, 70), die mit den Verbindungsstreifen (30, 40) kombiniert und den Kombinationsnuten (22, 23) zugewandt auf einer ersten Oberfläche (21a) der Schutzstromkreisplatte (21) angeordnet sind,
wobei die erste Oberfläche (21a) der Schutzstromkreisplatte (21) den Verbindungsstreifen (30, 40) zugewandt ist.

2. Wiederaufladbares Batteriepaket nach Anspruch 1, umfassend:
eine Mehrzahl von Elementarzellen (11, 12, 13, 14);
einen ersten (30) und einen zweiten (40) Verbindungsstreifen zum elektrischen Verbinden der Mehrzahl von Elementarzellen (11, 12, 13, 14) miteinander;
eine erste (50) und eine zweite (70) Verbindungsplatte, die mit dem ersten (30) bzw. zweiten (40) Verbindungsstreifen kombiniert sind; und
eine Schutzstromkreisplatte (21), in der eine erste Kombinationsnut (22) und eine zweite Kombinationsnut (23) der ersten Verbindungsplatte (50) bzw. der zweiten Verbindungsplatte (70) zugewandt sind.

3. Wiederaufladbares Batteriepaket nach einem der vorangehenden Ansprüche, wobei die Verbindungsplatten (50, 70) aus leitendem Material ausgebildet sind, um elektrisch mit der Schutzstromkreisplatte (21) verbunden zu sein.

4. Wiederaufladbares Batteriepaket nach einem der vorangehenden Ansprüche, wobei jeder Verbindungsstreifen (30, 40) einen Körper (31, 41) und einen vorstehenden Abschnitt (32, 42), der sich von einer Seite des Körpers (31, 41) zur jeweiligen Verbindungsplatte (50, 70) hin erstreckt, umfasst.

5. Wiederaufladbares Batteriepaket nach einem der vorangehenden Ansprüche, wobei jede Verbindungsplatte (50, 70) einen Verbindungsabschnitt (51, 71) und ein in dem Verbindungsabschnitt (51, 71) ausgebildetes Durchgangsloch (52, 72) umfasst und wobei ein vorstehender Abschnitt (32, 42) des jeweiligen Verbindungsstreifens (30, 40) in das Durchgangsloch (52, 72) eingeführt und mit diesem kombiniert ist.

6. Wiederaufladbares Batteriepaket nach einem der Ansprüche 4 oder 5, wobei der vorstehende Abschnitt (32, 42) jedes Verbindungsstreifens (30, 40) durch Löten mit einem Verbindungsabschnitt (51, 71) einer jeweiligen Verbindungsplatte (50, 70) kombiniert ist.

7. Wiederaufladbares Batteriepaket nach einem der Ansprüche 4 bis 6, wobei der vorstehende Abschnitt (32, 42) des jeweiligen Verbindungsstreifens (30, 40) derart in das Durchgangsloch (52, 72) der Verbindungsplatte (50, 70) eingeführt ist, dass die Spitze (321) des vorstehenden Abschnitts (32, 42) so positioniert ist, dass sie sich nicht oberhalb der Ebene einer zweiten Oberfläche (21b) der Schutzstromkreisplatte (21) gegenüber der ersten Oberfläche (21 a) erstreckt.

8. Wiederaufladbares Batteriepaket nach Anspruch 7, das weiterhin eine Bleisäure (60) umfasst, die den vorstehenden Abschnitt (32, 42) des Verbindungsstreifens (30, 40) mit dem Verbindungsabschnitt (51, 71) der Verbindungsplatte (50, 70) kombiniert, wobei sich die Höhe H1 der Bleisäure (60) nicht oberhalb der Ebene der zweiten Oberfläche (21b) der Schutzstromkreisplatte (21) erstreckt.

9. Wiederaufladbares Batteriepaket nach einem der vorangehenden Ansprüche, wobei die Verbindungsplatten weiterhin eine Mehrzahl von Vorsprüngen (513) auf der Oberfläche gegenüber der ersten Oberfläche (21a) der Schutzstromkreisplatte (21) umfassen.

10. Wiederaufladbares Batteriepaket nach einem der Ansprüche 5 bis 9, wobei die Verbindungsplatten einen Blockiervorsprung (522) umfassen, der sich von einem Ende des Verbindungsabschnitts aus erstreckt, wobei der Blockiervorsprung (522) mit einer Kombinationsnut der Schutzstromkreisplatte (21) in Eingriff ist.

11. Wiederaufladbares Batteriepaket nach einem der vorangehenden Ansprüche, wobei die Verbindungsplatten wenigstens eine Nut (531a, 531b) auf der Oberfläche gegenüber der ersten Oberfläche (21a) der Schutzstromkreisplatte (21) umfassen.

12. Wiederaufladbares Batteriepaket nach einem der Ansprüche 5 bis 11, wobei die Verbindungsplatten weiterhin einen Fixierungsabschnitt (543) umfassen, der von einer Seitenfläche des Verbindungsabschnitts aus vorsteht und dazu ausgebildet ist, mittels einer Presspassungstechnik mit der jeweiligen Kombinationsnut der Schutzstromkreisplatte (21) kombiniert zu sein.

13. Wiederaufladbares Batteriepaket nach Anspruch 12, wobei die Seitenfläche des Fixierungsabschnitts (543) der inneren Seitenfläche der jeweiligen Kombinationsnut der Schutzstromkreisplatte (21) zugewandt positioniert ist.

14. Wiederaufladbares Batteriepaket nach einem der Ansprüche 5 bis 13, wobei die Verbindungsplatten weiterhin einen konvexen Abschnitt (553, 563) umfassen, der sich von einem Ende des Verbindungsabschnitts in einer Richtung weg von der ersten Oberfläche der Schutzstromkreisplatte (21) erstreckt.

15. Wiederaufladbares Batteriepaket nach Anspruch 14, wobei die Verbindungsplatten weiterhin einen Kombinationsvorsprung (564) umfassen, der sich von einer unteren Fläche des konvexen Abschnitts (553, 563) aus erstreckt und so ausgebildet ist, dass das Ende des Kombinationsvorsprungs (564) zwischen der ersten Oberfläche (21a) und der zweiten Oberfläche (21b) der Schutzstromkreisplatte (21) positioniert ist.

## Revendications

1. Bloc-batterie rechargeable comprenant :
une pluralité de piles unitaires (11, 12, 13, 14) ;
des languettes de connexion (30, 40) pour connecter électriquement la pluralité de piles unitaires (11, 12, 13, 14) entre elles ;
une carte de circuit imprimé de protection (21) dans laquelle sont formées des rainures de combinaison (22, 23), **caractérisé par**
des plaques de connexion (50, 70) combinées par les languettes de raccordement (30, 40) et disposées sur une première surface (21a) de la carte de circuit imprimé de protection (21) pour faire face aux rainures de combinaison (22, 23),
dans lequel la première surface (21a) de la carte de circuit imprimé de protection (21) fait face aux languettes de connexion (30, 40).

2. Bloc-batterie rechargeable selon la revendication 1, comprenant :
une pluralité de piles unitaires (11, 12, 13, 14) ;
une première (30) et une seconde (40) languette de connexion pour connecter électriquement la pluralité de piles unitaires (11, 12, 13, 14) entre elles ;
une première (50) et une seconde (70) plaque de connexion combinées avec les première (30) et seconde (40) languettes de connexion respectivement ; et
une carte de circuit imprimé de protection (21) dans laquelle une première rainure de combinaison (22) et une seconde rainure de combinaison (23) font face à la première plaque de connexion (50) et à la seconde plaque de connexion (70), respectivement.

3. Bloc-batterie rechargeable selon l'une des revendications précédentes, dans lequel les plaques de connexion (50, 70) sont formées avec un matériau conducteur pour être électriquement connectées à la carte de circuit imprimé de protection (21).

4. Bloc-batterie rechargeable selon l'une des revendications précédentes, dans lequel chaque languette de connexion (30, 40) comprend un corps (31, 41) et une partie en saillie (32, 42) s'étendant à partir d'un côté du corps (31, 41) vers la plaque de connexion (50, 70) respective.

5. Bloc-batterie rechargeable selon l'une des revendications précédentes, dans lequel chaque plaque de connexion (50, 70) comprend une partie de connexion (51, 71) et un trou débouchant (52, 72) formé dans ladite partie de connexion (51, 71), et dans lequel une partie en saillie (32, 42) de la languette de connexion (30, 40) respective est insérée et combinée avec ledit trou débouchant (52, 72).

6. Bloc-batterie rechargeable selon l'une des revendications 4 ou 5, dans lequel la partie en saillie (32, 42) de chaque languette de connexion (30, 40) est combinée avec une partie de connexion (51, 71) d'une plaque de connexion (50, 70) respective par brasage tendre.

7. Bloc-batterie rechargeable selon l'une des revendications 4 à 6, dans lequel la partie en saillie (32, 42) de la languette de connexion (30, 40) respective est insérée dans le trou débouchant (52, 72) de ladite plaque de connexion (50, 70) de sorte que la pointe (321) de la partie en saillie (32, 42) est positionnée afin de ne pas s'étendre au-dessus du plan d'une seconde surface (21b) de la carte de circuit imprimé de protection (21) opposée à la première surface (21a).

8. Bloc-batterie rechargeable selon la revendication 7, comprenant en outre un acide de plomb (60) qui combine la partie en saillie (32, 42) de la languette de connexion (30, 40) avec la partie de connexion (51, 71) de la plaque de connexion (50, 70), dans lequel la hauteur H1 de l'acide de plomb (60) ne s'étend pas au-dessus du plan de la seconde surface (21b) de la carte de circuit imprimé de protection (21).

9. Bloc-batterie rechargeable selon l'une des revendications précédentes, dans lequel les plaques de connexion comprennent en outre une pluralité de saillies (513) sur la surface opposée à la première surface (21a) de la carte de circuit imprimé de protection (21).

10. Bloc-batterie rechargeable selon l'une des revendications 5 à 9, dans lequel les plaques de connexion comprennent une saillie de blocage (522) s'étendant à partir d'une extrémité de la partie de connexion, dans lequel la saillie de blocage (522) se met en prise avec une rainure de combinaison de la carte de circuit imprimé de protection (21) .

11. Bloc-batterie rechargeable selon l'une des revendications précédentes, dans lequel les plaques de connexion comprennent au moins une rainure (531a, 531b) sur la surface opposée à la première surface (21a) de la carte de circuit imprimé de protection (21).

12. Bloc-batterie rechargeable selon l'une des revendications 5 à 11, dans lequel les plaques de connexion comprennent en outre une partie de fixation (543) qui fait saillie d'une surface latérale de la partie de connexion et est formée pour se combiner avec la rainure de combinaison respective de la carte de circuit imprimé de protection (21) par une technologie d'ajustement à la presse.

13. Bloc-batterie rechargeable selon la revendication 12, dans lequel la surface latérale de la partie de fixation (543) est positionnée pour faire face à la surface latérale interne de la rainure de combinaison respective de la carte de circuit imprimé de combinaison (21) .

14. Bloc-batterie rechargeable selon l'une des revendications 5 à 13, dans lequel les plaques de connexion comprennent en outre une partie convexe (553, 563) qui s'étend à partir d'une extrémité de la partie de connexion dans une direction à distance de la première surface de la carte de circuit imprimé de protection (21).

15. Bloc-batterie rechargeable selon la revendication 14, dans lequel les plaques de connexion comprennent en outre une saillie de combinaison (564) s'étendant à partir d'une surface inférieure de la partie convexe (553, 563) et étant formée de sorte que l'extrémité de la saillie de combinaison (564) est positionnée entre la première surface (21a) et la seconde surface (21b) de la carte de circuit imprimé de protection (21).
